**Europäisches Patentamt**

**European Patent Office**

**Office européen des brevets**

(19)

(11) Veröffentlichungsnummer: **0 038 069**
**A2**

## EUROPÄISCHE PATENTANMELDUNG

(12)

(21) Anmeldenummer: 81102828.1

(22) Anmeldetag: **13.04.81**

(51) Int. Cl.³: **G 06 K 7/10,** H 03 K 13/18

(30) Priorität: 15.04.80 DE 3014467

(43) Veröffentlichungstag der Anmeldung: **21.10.81**
**Patentblatt 81/42**

(84) Benannte Vertragsstaaten: **CH FR GB IT LI NL**

(71) Anmelder: **SIEMENS AKTIENGESELLSCHAFT Berlin**
**und München, Postfach 22 02 61,**
**D-8000 München 22 (DE)**

(72) Erfinder: **Bauer, Paul, Ing. grad., Landshuter**
**Strasse 107, D-8300 Ergolding (DE)**

(54) Schaltungsanordnung zum Erkennen von strichförmigen Markierungen.

(57) Zum Erkennen von strichförmigen Markierungen bei einer Relativbewegung zwischen den Markierungen und einer optoelektronischen Abtasteinrichtung ist die optoelektronische Abtasteinrichtung mit zwei in Abtastrichtung geringfügig gegeneinander versetzt angeordneten Abtastern (A1, A2) versehen. Die Ausgangssignale (AB1, AB2) der Abtaster (A1, A2) liegen einerseits an einer Differenzsignale (DI) erzeugenden Differenzstufe (D) und andererseits an einer Summensignale (SU) erzeugenden Summierstufe (S) an. Wenn ein Summensignal (SU) auftritt und gleichzeitig ein Differenzsignal (D) einen Nulldurchgang aufweist, erzeugt eine Auswertestufe (AW) ein der Markierung zugeordnetes Signal.

EP 0 038 069 A2

0038069

SIEMENS AKTIENGESELLSCHAFT    Unser Zeichen
Berlin und München           VPA    80 P 8022 E

Schaltungsanordnung zum Erkennen von strichförmigen Markierungen.

Die Erfindung bezieht sich auf eine Schaltungsanordnung zum Erkennen von strichförmigen Markierungen, bei der die beleuchteten Markierungen während einer Relativbewegung zwischen einer optoelektronischen Abtasteinrichtung und den Markierungen abgetastet werden.

Es ist allgemein bekannt, strichförmige Markierungen unter Verwendung einer optoelektronischen Abtasteinrichtung abzutasten. Üblicherweise wird zu diesem Zweck in der Abtasteinrichtung ein Abtaster, beispielsweise ein Fototransistor angeordnet. Die mit den Markierungen versehene Vorlage wird mittels einer Lichtquelle, beispielsweise einer Leuchtdiode beleuchtet. In Abhängigkeit von der Farbe der Markierung weist das von dem Abtaster abgegebene Abtastsignal einen Maximal- oder einen Minimalwert auf, wenn sich die Markierung genau unter dem Abtaster befindet. Die Ermittlung des Maximal- oder Minimalwerts erweist sich jedoch als sehr schwierig, so daß die Markierung nicht mit hinreichender Genauigkeit erkannt werden kann.

Der Erfindung liegt daher die Aufgabe zugrunde, eine Schaltungsanordnung anzugeben, mit der strichförmige Markierungen bei einer Relativbewegung zwischen den Markierungen und der optoelektronischen Abtasteinrichtung mit großer Genauigkeit erkannt werden.

Erfindungsgemäß wird die Aufgabe bei der Schaltungsanordnung der eingangs genannten Art dadurch gelöst, daß die optoelektronische Abtasteinrichtung zwei in Abtastrichtung geringfügig gegeneinander versetzt angeordnete, optoelek-

Ret 1 Ram /14.4.1980

0038069

tronische Abtaster enthält, daß von den Abtastern abgegebene Abtastsignale einerseits an einer Differenzsignale erzeugenden Differenzstufe und andererseits an einer Summensignale erzeugenden Summierstufe anliegen, daß die Differenzsignale einem Nulldurchgangssignale erzeugenden Nulldurchgangsdetektor zugeführt werden und daß die Summensignale und die Nulldurchgangssignale an einer Auswertestufe anliegen, die beim Vorliegen eines Summensignals und beim Auftreten eines Nulldurchgangssignals die Markierung erkennt.

Die Anordnung gemäß der Erfindung hat den Vorteil, daß sie Markierungen mit großer Störsicherheit erkennt. Bei verhältnismäßig breiten Markierungen gibt die Schaltungsanordnung ein die Mitte der Markierung genau kennzeichnendes Signal ab.

Die Differenzsignale werden auf einfache Weise erzeugt, wenn als Differenzstufe ein Operationsverstärker vorgesehen ist, an dessen Eingängen die Abtastsignale der Abtaster anliegen.

Die Summensignale werden auf einfache Weise erzeugt, wenn die Summierstufe als Operationsverstärker ausgebildet ist, an dessen einem Eingang die Abtastsignale anliegen. Um die Summensignale erst dann zu erzeugen, wenn die Abtastsignale vorgegebene Werte überschreiten, ist es vorteilhaft, wenn am einen Eingang des Operationsverstärkers der Summierstufe der Mittelabgriff eines Spannungsteilers angeschlossen ist. Auf diese Weise erzeugt die Summierstufe immer erst dann ein Summensignal, wenn die Summe der Abtastsignale eine vorgegebene Schwelle überschreitet.

Zum Erzeugen einer Hysterese in der Summierstufe ist es zweckmäßig, wenn der andere Eingang des Operationsverstärkers der Summierstufe über jeweils einen Widerstand mit dem Ausgang der Summierstufe und mit einem Bezugspotential verbunden ist.

Falls die beiden Abtaster in der optoelektronischen Abtasteinrichtung als Fototransistoren ausgebildet sind, wird eine
Stabilisierung der Arbeitspunkte der Fototransistoren auf
einfache Weise dadurch erreicht, daß jedem Fototransistor
die Betriebsspannung über einen Feldeffekttransistor zugeführt wird. Zur Impedanzwandlung kann es auch vorteilhaft
sein, wenn jedem Fototransistor ein als Operationsverstärker ausgebildeter Impedanzwandler nachgeschaltet ist.

Bei einer Abtastung von schmalen Markierungen wird eine
günstige Anordnung der Abtaster dadurch erreicht, daß die
Abtaster auch senkrecht zur Abtastrichtung gegeneinander
versetzt angeordnet sind.

Im folgenden wird ein Ausführungsbeispiel der Schaltungsanordnung gemäß der Erfindung anhand von Zeichnungen näher
beschrieben. Es zeigen:
Fig. 1 ein Schaltbild der Schaltungsanordnung,
Fig. 2 ein Signalbild von Signalen an verschiedenen Punkten der Schaltungsanordnung.

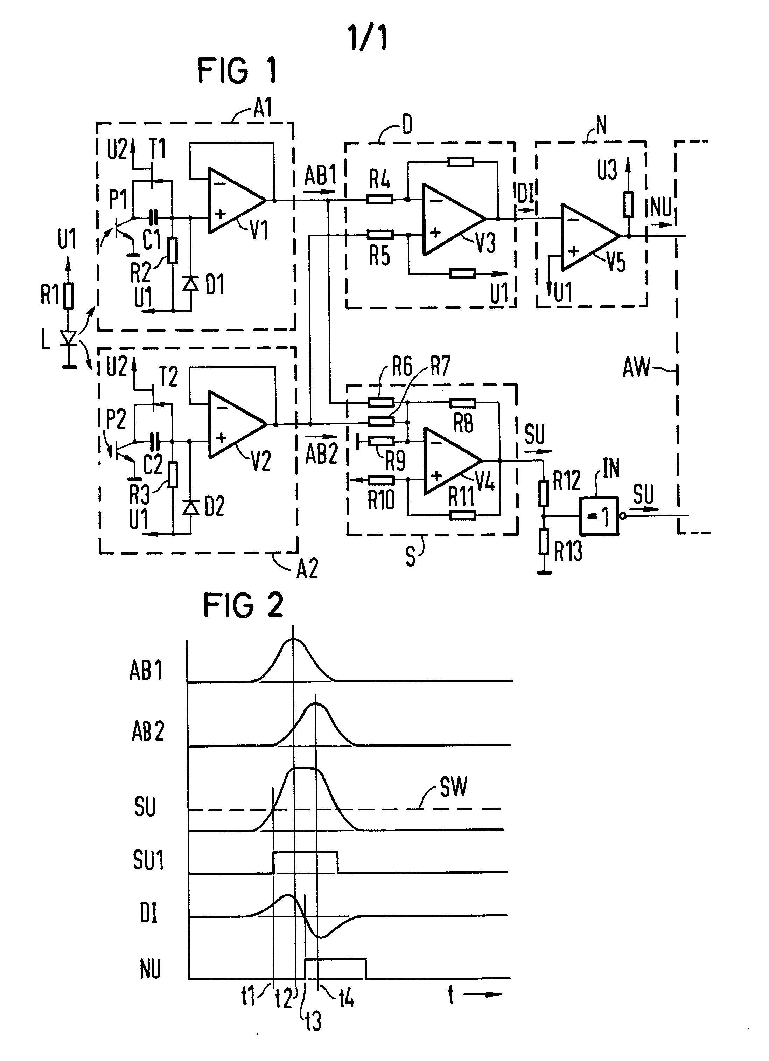

Die in Fig. 1 dargestellte Schaltungsanordnung enthält zwei
optoelektronische Abtaster A1 und A2, die in einer Abtasteinrichtung zum Abtasten von strichförmigen Markierungen
in Abtastrichtung angeordnet sind. In den Abtastern A1 und
A2 vorgesehene Fototransistoren P1 und P2 sind in Abtastrichtung und gegebenenfalls senkrecht zur Abtasteinrichtung
gegeneinander versetzt angeordnet. Eine aus einem Widerstand
R1, an dem eine Betriebsspannung U1 anliegt und einer Leuchtdiode L gebildete Lichtquelle beleuchtet die abzutastenden
Markierungen. Das von der Leuchtdiode L ausgesandte Licht
gelangt entweder als Durchlicht oder als reflektiertes Licht
infolge einer Relativbewegung des Trägers mit den Markierungen und der Abtasteinrichtung zeitlich nacheinander zu
den Fototransistoren P1 und P2 in den Abtastern A1 und A2.
Falls beispielsweise die Markierungen als schwarze Striche
auf einem hellen Untergrund ausgebildet sind und die Fototransistoren P1 und P2 das reflektierte Licht empfangen, werden diese immer dann leitend gesteuert, wenn bei einer Relativbewegung zwischen den Markierungen und den Abtastern A1 und A2 der weiße Untergrund vorliegt und immer dann gesperrt, wenn die Markierungen auftreten. Zur Stabilisierung der Arbeitspunkte der Fototransistoren P1 und P2 sind deren Kollektoren über jeweils einen Feldeffekttransistor T1 bzw. T2 mit einer Betriebsspannung U2 verbunden. Die Ansteuerung der Feldeffekttransistoren T1 und T2 erfolgt über jeweils einen Widerstand R2 bzw. R3 und eine parallel geschaltete Diode D1 bzw. D2, die mit der Betriebsspannung U1 verbunden sind. Die von den Fototransistoren P1 und P2 abgegebenen Signale werden über jeweils einen Kondensator C1 bzw. C2 jeweils einem Operationsverstärker V1 bzw. V2 zugeführt, der als Impedanzwandler ausgebildet ist.

Die von den Impedanzwandlern abgegebenen Abtastsignale AB1 und AB2 werden einerseits einer aus einem Operationsverstärker V3 gebildeten Differenzierstufe D und andererseits einer aus einem Operationsverstärker V4 gebildeten Summierstufe S zugeführt. Die Differenzstufe D bildet die Differenz zwischen den Abtastsignalen AB1 und AB2 und erzeugt ein Differenzsignal DI, das einem aus einem Operationsverstärker V5 gebildeten Nulldurchgangsdetektor N zugeführt wird. Die Differenzstufe D ist in bekannter Weise ausgebildet und die Abtastsignale AB1 un AB2 werden über Widerstände R4 und R5 dem Operationsverstärker V3 zugeführt. Im Nulldurchgangsdetektor N wird das Differenzsignal DI dem invertierenden Eingang des Operationsverstärkers V5 zugeführt. An seinem nichtinvertierenden Eingang liegt die Betriebsspannung U1 als Bezugspotential an. An seinem Ausgang gibt der Nulldurchgangsdetektor N ein Nulldurchgangssignal NU ab, das seinen Binärwert in einer vorgegebenen Richtung immer dann ändert, wenn die Differenz zwischen den Abtastsignalen AB1 und AB2 gleich Null ist. Der Binärwert wird durch eine Betriebsspannung U3 bestimmt.

In der Summierstufe S werden die Abtastsignale AB1 und AB2 über Widerstände R6 und R7 dem invertierenden Eingang des Operationsverstärkers V4 zugeführt. Dieser Eingang ist auch mit dem Mittelabgriff eines aus Widerständen R8 und R9 gebildeten Spannungsteilers verbunden. Dieser Spannungsteiler sorgt dafür, daß ein Summensignal SU immer erst dann abgegeben wird, wenn die Summe aus den beiden Abtastsignalen AB1 und AB2 eine vorgegebene Schwelle SW überschreitet. Der andere Eingang des Operationsverstärkers V4 ist einerseits über einen Widerstand R10 mit der Betriebsspannung U2 und andererseits über einen Widerstand R11 mit seinem Ausgang verbunden, um eine Hysterese beim Schalten des Operationsverstärkers V4 zu erreichen. Das Summensignal SU wird einem aus zwei Widerständen R12 und R13 gebildeten Spannungsteiler zugeführt, dessen Mittelabgriff der Inverter nachgeschaltet ist. Am Ausgang des Inverters IN wird ein am Summensignal SU zugeordnetes, digitalisiertes Summensignal SU1 abgegeben.

Das Summensignal SU1 und das Nulldurchgangssignal NU werden einer Auswertestufe AW zugeführt, die die Markierung erkennt, wenn das Summensignal SU1 vorhanden ist und gleichzeitig das Nulldurchgangssignal NU seinen Binärwert in vorgegebener Weise ändert. Im einfachsten Fall besteht die Auswertestufe AW aus einem UND-Glied, dessen Eingängen das Summensignal SU1 und das Nulldurchgangssignal NU zugeführt werden.

Weitere Einzelheiten der Schaltungsanordnung werden im folgenden zusammen mit den in Fig. 2 dargestellten Zeitdiagrammen beschrieben.

Bei den in Fig. 2 dargestellten Zeitdiagrammen sind in Abszissenrichtung die Zeit t und in Ordinatenrichtung die Momentanwerte von Signalen an verschiedenen Punkten der Schaltungsanordnung dargestellt.

0038069

Bei einer Relativbewegung zwischen den Abtastern A1 und A2 und einer strichförmigen Markierung werden zeitlich nacheinander zu den Zeitpunkten t2 und t4 die Abtastsignale AB1 und AB2 erzeugt. Die Abtastsignale AB1 und AB2 haben einen glockenähnlichen Verlauf. Der Summierer SU summiert die Abtastsignale AB1 und AB2 und erzeugt das Summensignal SU, wenn die Summe die durch die Widerstände R8 und R9 festgelegte Schwelle SW zum Zeitpunkt t1 überschreitet. Der Inverter IN digitalisiert das Summensignal SU und gibt zum Zeitpunkt t1 das binäre Summensignal SU1 ab.

Die Differenzstufe D bildet die Differenz zwischen den Abtastsignalen AB1 und AB2 und erzeugt das Differenzsignal DI. Zwischen den beiden Maximalwerten der Abtastsignale AB1 und AB2 zu den Zeitpunkten t2 bzw. t4 unterschreitet das Differenzsignal DI zum Zeitpunkt t3 die Nullinie. Der Nulldurchgangsdetektor N erkennt den Nulldurchgang und gibt das binäre Nulldurchgangssignal NU ab, das zum Zeitpunkt t3 den Binärwert 1 annimmt.

Das Summensignal SU1 und das Nulldurchgangssignal NU werden der Auswertestufe AW zugeführt. Diese erkennt aus einer Verknüpfung dieser beiden Signale die genaue zeitliche Lage der Markierung.

Durch die Verknüpfung des Summensignals SU1 und des Nulldurchgangssignals NU wird eine große Störsicherheit der Schaltungsanordnung erreicht. Der Nulldurchgang des Differenzsignals DI wird nur dann ausgewertet, wenn ein entsprechend großes Summensignal SU vorhanden ist. Damit ist sichergestellt, daß Störsignale, die die Nullinie überschreiten oder unterschreiten, nicht fälschlicherweise als Markierungen erkannt werden.

8 Patentansprüche
2 Figuren

0038069

<u>Patentansprüche</u>

1. Schaltungsanordnung zum Erkennen von strichförmigen Markierungen, bei der die beleuchteten Markierungen während einer Relativbewegung zwischen einer optoelektronischen Abtasteinrichtung und den Markierungen abgetastet werden, d a d u r c h g e k e n n z e i c h n e t, daß die optoelektronische Abtasteinrichtung zwei in Abtastrichtung geringfügig gegeneinander versetzt angeordnete optoelektronische Abtaster (A1, A2) enthält, daß von den Abtastern (A1, A2) abgegebene Abtastsignale (AB1, AB2) einerseits an einer Differenzsignale (DI) erzeugenden Differenzstufe (D) und andererseits an einer Summensignale (SU) erzeugenden Summierstufe (S) anliegen, daß die Differenzsignale einem Nulldurchgangssignale (NU) erzeugenden Nulldurchgangsdetektor zugeführt werden und daß die Summensignale (SU) und die Nulldurchgangssignale (NU) an einer Auswertestufe (AW) anliegen, die beim Vorliegen eines Summensignals (SU) und beim Auftreten eines Nulldurchgangssignals (NU) die Markierung erkennt.

2. Schaltungsanordnung nach Anspruch 1, d a d u r c h g e k e n n z e i c h n e t, daß als Differenzstufe (D) ein Operationsverstärker (V3) vorgesehen ist, an dessen Eingängen die Abtastsignale (AB1, AB2) anliegen.

3. Schaltungsanordnung nach Anspruch 1 oder Anspruch 2, d a d u r c h g e k e n n z e i c h n e t, daß die Summierstufe (S) als Operationsverstärker (V4) ausgebildet ist, an dessen einem Eingang die Abtastsignale (AB1, AB2) anliegen.

4. Schaltungsanordnung nach Anspruch 3, d a d u r c h g e k e n n z e i c h n e t, daß am einen Eingang des Operationsverstärkers (V4) der Summierstufe (S) der Mittelabgriff eines Spannungsteilers (R8, R9) angeschlossen ist.

5. Schaltungsanordnung nach Anspruch 3 oder Anspruch 4, d a d u r c h  g e k e n n z e i c h n e t, daß der andere Eingang des Operationsverstärkers (V4) der Summierstufe (S) über jeweils einen Widerstand (R10, R11) mit dem Ausgang des Operationsverstärkers (V4) und mit einem Bezugspotential (U2) verbunden ist.

6. Schaltungsanordnung nach einem der Ansprüche 1 bis 5, bei der jeder Abtaster einen Fototransistor enthält, d a d u r c h  g e k e n n z e i c h n e t, daß jedem Fototransistor (P1, P2) die Betriebsspannung (U1) über einen Feldeffekttransistor (T1, T2) zugeführt wird.

7. Anordnung nach Anspruch 6, d a d u r c h  g e - k e n n z e i c h n e t, daß jedem Fototransistor (P1, P2) ein als Operationsverstärker (V1, V2) ausgebildeter Impedanzwandler nachgeschaltet ist.

8. Anordnung nach einem der Ansprüche 1 bis 7, d a - d u r c h  g e k e n n z e i c h n e t, daß die Abtaster (A1, A2) in Abtastrichtung und senkrecht zur Abtastrichtung gegeneinander versetzt angeordnet sind.

**FIG 1**

**FIG 2**